# EUROPEAN PATENT APPLICATION

(11) **EP 4 083 252 A1**
(43) Date of publication of application: **02.11.2022**
(21) Application number: 20888722.4
(22) Date of filing: 22.12.2020
(51) Int. Cl.: C23C 14/32, C23C 14/04, C23C 14/06, H01M 4/525, H01M 10/0562, H05H 1/46

(54) **THIN FILM MANUFACTURING APPARATUS**

(30) Priority: 26.12.2019 JP 2019236186
(71) Applicant: ULVAC, Inc., Chigasaki-shi, Kanagawa 253-8543 (JP)
(72) Inventor: GIBO, Manabu, Chigasaki-shi, Kanagawa 253-8543 (JP); KURAUCHI, Toshiharu, Chigasaki-shi, Kanagawa 253-8543 (JP); EHIRA, Hiroshi, Chigasaki-shi, Kanagawa 253-8543 (JP)
(74) Representative: Zacco GmbH
(86) International application number: PCT/JP2020/047911
(87) International publication number: WO 2021/132230

(57) **Abstract**

The invention provides an apparatus that causes film formation particles to adhere to a surface of a substrate moving in a hermetically-sealable chamber and thereby forms a thin film thereon and includes: a plasma generator; a substrate transfer unit; a film-formation source supplier; and a film-formation region limiter. The plasma generator includes a magnet located at the other surface of the substrate and a gas supplier that supplies a film forming gas to near the surface of the substrate. The film-formation region limiter includes a shield that is located close to the surface of the substrate and has an opening. The ratio of a diameter of the opening of the shield to a diameter of the plasma generated by the plasma generator in a direction along the surface of the substrate is in a range of less than or equal to 110/100.

## Description

### TECHNICAL FIELD

The present invention relates to a thin film manufacturing apparatus and particularly relates to a preferred technique when a film is formed by use of plasma.

This application claims priority from Japanese Patent Application No. 2019-236186 filed on December 26, 2019, the contents of which are incorporated herein by reference in their entirety.

### BACKGROUND ART

Various researches on lithium-ion batteries have been conducted. Particularly, as batteries that combine safety, high energy density, and a long product life, development of all-solid-state batteries that are constituted of a negative electrode, an electrolyte, and a positive electrode which are all formed in a solid state has been expected.

As a method of manufacturing an electrolyte layer used in the all-solid-state battery, it is necessary to form a film containing lithium, as disclosed by Patent Documents 1 and 2, film formation is carried out by plasma vapor deposition.

In the step of forming such electrolyte layer, it is known that, for example, film formation is carried out by use of an evaporator including lithium and phosphorus by plasma containing nitrogen, and thereby a film containing nitrogen is formed.

Additionally, for increase in performance of lithium-ion batteries, improvement of film quality, particularly, improvement of ion conductivity of the electrolyte layer has been desired.

### PRIOR ART DOCUMENTS

### PATENT DOCUMENTS

[Patent Document 1] Japanese Unexamined Patent Application, First Publication No. 2005-068554
[Patent Document 2] Japanese Unexamined Patent Application, First Publication No. 2007-005149

### SUMMARY OF THE INVENTION

### PROBLEMS TO BE SOLVED BY THE INVENTION

However, in the technique disclosed by Patent Documents 1 and 2, a desired film quality has not been obtained.

The invention was made in view of the above-described situation, and achieves the following objects.
1. Achievement of formation of an electrolyte layer having improved film characteristics.
2. Making the characteristics of the formed electrolyte layer uniform.

### MEANS FOR SOLVING THE PROBLEMS

The thin-film manufacturing apparatus of the invention is an apparatus that causes film formation particles to adhere to a surface of a substrate moving in a hermetically-sealable chamber and thereby forms a thin film thereon, including: a plasma generator that generates plasma in the chamber; a substrate transfer unit that transfers the substrate in the chamber; a film-formation source supplier that supplies film formation particles to the surface of the substrate; and a film-formation region limiter that limits a film-formation region to which the film formation particles are to be formed on the surface of the substrate from the film-formation source supplier, wherein the plasma generator includes: a magnet located at the other surface of the substrate; and a gas supplier that supplies a film forming gas to near the surface of the substrate, the film-formation region limiter includes a shield that is located close to the surface of the substrate and has an opening, and a ratio of a diameter of the opening of the shield to a diameter of the plasma generated by the plasma generator in a direction along the surface of the substrate is in a range of less than or equal to 110/100. According to the invention, the above-described problem is solved.

In the thin-film manufacturing apparatus, a ratio of a diameter of the opening of the shield to a diameter of the magnet in a direction along the surface of the substrate may be in a range of less than or equal to 110/90.

The thin-film manufacturing apparatus of the invention is an apparatus that causes film formation particles to adhere to a surface of a substrate moving in a hermetically-sealable chamber and thereby forms a thin film thereon, including: a plasma generator that generates plasma in the chamber; a substrate transfer unit that transfers the substrate in the chamber; a film-formation source supplier that supplies film formation particles to the surface of the substrate; and a film-formation region limiter that limits a film-formation region to which the film formation particles are to be formed on the surface of the substrate from the film-formation source supplier, wherein the plasma generator includes: a magnet located at the other surface of the substrate; and a gas supplier that supplies a film forming gas to near the surface of the substrate, the film-formation region limiter includes a shield that is located close to the surface of the substrate and has an opening, and a length obtained by subtracting a diameter of the opening of the shield from a diameter of the plasma generated by the plasma generator in a direction along the surface of the substrate is in a length range of less than or equal to a length obtained by adding 20 mm to an outer diameter of the magnet. According to the invention, the above-described problem is solved.

In the thin-film manufacturing apparatus, the film-formation region limiter may be grounded and thereby has a ground potential, and a diameter of the opening may be set in a length obtained by adding a length range of 0 mm to 20 mm to an outer diameter of the magnet.

In the thin-film manufacturing apparatus, the film-formation region limiter may have a floating potential, and a diameter of the opening may be set in a length obtained by adding a length range of -20 mm to +20 mm to an outer diameter of the magnet.

In the thin-film manufacturing apparatus, a diameter of the opening may be determined in a predetermined range in a direction of movement of the substrate.

In the thin-film manufacturing apparatus, the film forming gas supplied by the gas supplier may contain nitrogen, and the film-formation source supplier may supply a film-formation source that contains lithium.

The thin-film manufacturing apparatus of the invention is an apparatus that causes film formation particles to adhere to a surface of a substrate moving in a hermetically-sealable chamber and thereby forms a thin film thereon, including: a plasma generator that generates plasma in the chamber; a substrate transfer unit that transfers the substrate in the chamber; a film-formation source supplier that supplies film formation particles to the surface of the substrate; and a film-formation region limiter that limits a film-formation region to which the film formation particles are to be formed on the surface of the substrate from the film-formation source supplier, wherein the plasma generator includes: a magnet located at the other surface of the substrate; and a gas supplier that supplies a film forming gas to near the surface of the substrate, the film-formation region limiter includes a shield that is located close to the surface of the substrate and has an opening, and a ratio of a diameter of the opening of the shield to a diameter of the plasma generated by the plasma generator in a direction along the surface of the substrate is in a range of less than or equal to 110/100.

According to the invention, as a result of setting the diameter of the opening to be in the above-mentioned range with respect to the diameter of plasma, the film formation particles can be shielded by the shield such that the particles to be deposited on a substrate by a low-activated plasma generated at a peripheral edge portion are not adhered to the substrate. Consequently, the film characteristics of the thin film to be deposited are not degraded, and it is possible to form the thin film having the preferred film characteristics.

In the thin-film manufacturing apparatus, a ratio of a diameter of the opening of the shield to a diameter of the magnet in a direction along the surface of the substrate is in a range of less than or equal to 110/90.

Accordingly, as a result of setting the diameter of the opening to be in the above-mentioned range with respect to the diameter of the magnet, the film formation particles are shielded by the shield such that the particles to be deposited on a substrate by a low-activated plasma generated at a peripheral edge portion are not adhered to the substrate. Because of this, the film characteristics of the thin film to be deposited is not degraded, it is possible to form the thin film having the preferred film characteristics.

The thin-film manufacturing apparatus of the invention is an apparatus that causes film formation particles to adhere to a surface of a substrate moving in a hermetically-sealable chamber and thereby forms a thin film thereon, including: a plasma generator that generates plasma in the chamber; a substrate transfer unit that transfers the substrate in the chamber; a film-formation source supplier that supplies film formation particles to the surface of the substrate; and a film-formation region limiter that limits a film-formation region to which the film formation particles are to be formed on the surface of the substrate from the film-formation source supplier, wherein the plasma generator includes: a magnet located at the other surface of the substrate (located on the opposite side of the surface of the substrate); and a gas supplier that supplies a film forming gas to near the surface of the substrate, the film-formation region limiter includes a shield that is located close to the surface of the substrate and has an opening, and a length obtained by subtracting a diameter of the opening of the shield from a diameter of the plasma generated by the plasma generator in a direction along the surface of the substrate is in a length range of less than or equal to a length obtained by adding 20 mm to an outer diameter of the magnet.

In other words, the diameter of the opening of the shield with respect to a diameter of the plasma generated by the plasma generator in a direction along the surface of the substrate is in a range of less than or equal to the outer diameter of the magnet +20 mm (a range of less than or equal to the length obtained by adding 20 mm to the outer diameter of the magnet).

As a result of setting the diameter of the opening to be in the above-mentioned range with respect to the diameter of plasma, the film formation particles can be shielded by the shield such that the particles to be deposited on a substrate by a low-activated plasma generated at a peripheral edge portion are not adhered to the substrate. For this reason, the film characteristics of the thin film to be deposited are not degraded, it is possible to form the thin film having the preferred film characteristics.

In the thin-film manufacturing apparatus, the film-formation region limiter may be grounded and thereby has a ground potential, and a diameter of the opening is set in a length obtained by adding a length range of 0 mm to 20 mm to an outer diameter of the magnet.

In other words, the size of the opening is set in a range of the outer diameter of the magnet +0 mm to 20 mm (a range of "the outer diameter of the magnet" to "the length obtained by adding 20 mm to the outer diameter of the magnet").

Accordingly, as a result of setting the diameter of the opening to be in the above-mentioned range with respect to the diameter of the magnet, the film formation particles are shielded by the shield such that the particles to be deposited on a substrate by a low-activated plasma generated at a peripheral edge portion are not adhered to the substrate. Consequently, the film characteristics of the thin film to be deposited are not degraded, it is possible to form the thin film having the preferred film characteristics.

In the thin-film manufacturing apparatus, the film-formation region limiter has a floating potential, and a diameter of the opening is set in a length obtained by adding a length range of -20 mm to +20 mm to an outer diameter of the magnet.

In other words, the size of the opening is set in a range of the outer diameter of the magnet -20 mm to +20 mm (a range of "the length obtained by subtracting 20 mm from the outer diameter of the magnet" to "the length obtained by adding 20 mm to the outer diameter of the magnet").

Accordingly, as a result of setting the diameter of the opening to be in the above-mentioned range with respect to the diameter of the magnet, the film formation particles are shielded by the shield such that the particles to be deposited on a substrate by a low-activated plasma generated at a peripheral edge portion are not adhered to the substrate. Because of this, the film characteristics of the thin film to be deposited is not degraded, it is possible to form the thin film having the preferred film characteristics.

In the thin-film manufacturing apparatus, a diameter of the opening is determined in a predetermined range in a direction of movement of the substrate.

Therefore, while the substrate moves, the film formation particles are shielded by the shield on the entire area of the opening serving as the film formation region such that the particles to be deposited on a substrate by a low-activated plasma generated at a peripheral edge portion are not adhered to the substrate, and as a result, the film characteristics of the thin film to be deposited is not degraded, it is possible to form the thin film having the preferred film characteristics.

Note that, in the direction intersecting with the direction in which the substrate moves, particularly, in the direction orthogonal to the direction in which the substrate moves, the activation level of plasma can be uniform. Thus, on the entire area of the film formation region, the activation level of the film formation particles activated by plasma is made uniform, and the formation of the film having the film characteristics such that the film formation characteristics are uniform on the entire area of the substrate can be carried out.

In the thin-film manufacturing apparatus, the film forming gas supplied by the gas supplier contains nitrogen, and the film-formation source supplier supplies a film-formation source that contains lithium.

Accordingly, when the electrolyte layer containing lithium is formed, nitrogen activated in a desired state is added thereto, and therefore it is possible to form the electrolyte layer having the preferred film characteristics.

Because of this, the preferred electrolyte layer for use in a lithium-ion battery can be formed. Particularly, it is possible to provide the manufacturing apparatus that can form a lithium-containing film having improved ion conductivity.

### Effects of the Invention

According to the invention, the effects can be obtained in that when the electrolyte layer containing lithium is formed, nitrogen activated in a desired state is added thereto, and therefore it is possible to form the electrolyte layer having the preferred film characteristics, the preferred electrolyte layer for use in a lithium-ion battery can be formed, and particularly, it is possible to provide the manufacturing apparatus that can form a lithium-containing film having improved ion conductivity.

### BRIEF DESCRIPTION OF THE DRAWINGS

FIG. 1 is a schematic cross-sectional side view showing a thin film manufacturing apparatus according to a first embodiment of the invention.
FIG. 2 is an enlarged cross-sectional view showing a portion near a film formation region of the thin film manufacturing apparatus according to the first embodiment of the invention.
FIG. 3 is a bottom view showing a portion near a film formation region of the thin film manufacturing apparatus according to the first embodiment of the invention when seen from a bottom thereof.
FIG. 4 is a bottom view showing a portion near a film formation region of a thin film manufacturing apparatus according to a second embodiment of the invention when seen from a bottom thereof.

### EMBODIMENTS FOR CARRYING OUT THE INVENTION

Hereinafter, a thin film manufacturing apparatus according to a first embodiment of the invention will be described with reference to drawings.

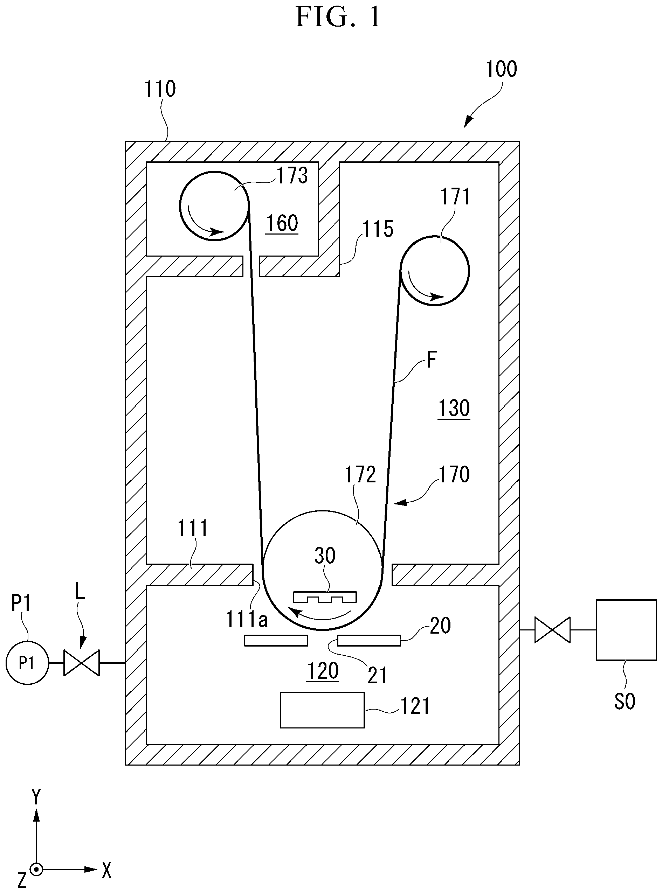

FIG. 1 is a schematic cross-sectional side view showing a thin film manufacturing apparatus according to the embodiment, and reference numeral 100 represents a thin film manufacturing apparatus in FIG. 1. In FIG. 1, the X-axis, Y-axis, and Z-axis directions which are orthogonal to each other indicate three axis directions, the X-axis and the Y-axis indicate a horizontal direction, and the Z-axis direction indicates a vertical direction.

As shown in FIG. 1, the thin film manufacturing apparatus 100 according to the embodiment includes a vacuum chamber (chamber) 110, a film formation unit 120, a transfer unit (substrate transfer unit) 130, a collection unit (substrate transfer unit) 160, and a transfer mechanism (substrate transfer unit) 170.

The vacuum chamber 110 has a hermetically-sealable structure and is connected to a first discharge line L provided with a vacuum pump P1. Therefore, the vacuum chamber 110 is configured such that the internal side thereof can be discharged so as to be a predetermined reduced-pressure atmosphere and the reduced-pressure atmosphere can be maintained. In addition, as shown in FIG. 1, the vacuum chamber 110 includes a plurality of partition plates 111 and 115 that separate the film formation unit 120, the transfer unit 130, and the collection unit 160 to each other.

The film formation unit 120 is a film formation chamber that is partitioned by the partition plate 111 and the outer wall of the vacuum chamber 110, and an evaporation source 121 is provided thereinside. Additionally, the film formation unit 120 is connected to the first discharge line L. Consequently, when the vacuum chamber 110 is vacuumed, firstly, the inside of the film formation unit 120 is vacuumed.

On the other hand, since the film formation unit 120 is communicated with the transfer unit 130, when the inside of the film formation unit 120 is vacuumed, the inside of the transfer unit 130 is also vacuumed. For this reason, a difference in pressure occurs between the film formation unit 120 and the transfer unit 130. Due to the pressure difference, a vaporization flow of raw materials containing lithium which will be described later is prevented from entering the inside of the transfer unit 130. A gas supplier SO that supplies a film forming gas is connected to the film formation unit 120. The gas supplier S0 is configured as a plasma generator. The gas supplier SO can supply a film forming gas containing nitrogen.

The evaporation source (film-formation source supplier) 121 is an evaporation source that evaporates raw materials containing lithium, for example, is configured by a resistance heating evaporation source, an inductive heating evaporation source, an electron beam heating evaporation source, or the like.

The transfer unit 130 is a transfer chamber that is partitioned by the partition plate 115 and the outer wall of the vacuum chamber 110, and is disposed at the upper portion of the inside of the vacuum chamber 110 in the Y-axis direction. The first discharge line L is only connected to the film formation unit 120 in the embodiment but the transfer unit 130 and the film formation unit 120 may be independently vacuumed by also connecting a separate discharge line to the transfer unit 130.

The transfer mechanism (substrate transfer unit) 170 includes an unwinding roller 171, a main roller 172, and a rewinding roller 173.

Each of the unwinding roller 171, the main roller 172, and the rewinding roller 173 includes a rotation driver that is not shown in the drawings and is configured to be able to rotate in the direction around the Z-axis at a predetermined rate of rotation and in the direction of arrow shown in FIG. 1. Therefore, in the vacuum chamber 110, a base member F (substrate) is fed from the unwinding roller 171 to the rewinding roller 173 at a predetermined feed speed.

The unwinding roller 171 is provided at the upstream side of the film formation unit 120 in the transfer direction of the base member F and has a function of sending the base member F to the main roller 172. Note that, the appropriate number of guide rollers (not shown in the drawings) which do not include an independent rotation driver may be disposed at suitable positions between the unwinding roller 171 and the main roller 172.

The main roller 172 is disposed between the unwinding roller 171 and the rewinding roller 173 in the transfer direction of the base member F. At least part of the bottom portion of the main roller 172 in the Y-axis direction is disposed at the position at which it faces the film formation unit 120 through an opening portion 111a provided at the partition plate 111. The main roller 172 is spaced apart at a predetermined distance, faces the opening portion 111a, and faces the evaporation source 121 in the Y-axis direction. The main roller 172 is formed of a metal material such as stainless steel, iron, aluminum, or the like and formed in a cylindrical shape, and, for example, a temperature control mechanism such as a temperature-controlling medium circulation system which is not shown in the drawings may be provided thereinside. The size of the main roller 172 is not particularly limited, and typically, a width thereof in the Z-axis direction is set to be larger than the width of the base member F in the Z-axis direction.

The rewinding roller 173 is disposed inside the collection unit 160 that is a space partitioned by the partition plate 115 and the outer wall of the vacuum chamber 110 and has a function of collecting the base member F that is unwound from the unwinding roller 171. An evaporation material containing lithium is deposited on the base member F that has passed through the film formation unit 120 and collected by the rewinding roller 173. The appropriate number of guide rollers (not shown in the drawings) which do not include an independent rotation driver may be disposed at suitable positions between the rewinding roller 173 and the main roller 172. Note that, the partition plate 115 may not be provided.

The base member F is, for example, an elongated film that is cut to have a predetermined width. The base member F is formed of a metal such as copper, aluminum, nickel, stainless steel, or the like. The material of the base member F is not limited to a metal. As the material of the base member F, a resin film may be used, such as an OPP (oriented polypropylene) film, a PET (polyethylene terephthalate) film, a PPS (polyphenylene sulfide) film, a PI (polyimide) film, or the like. The thickness of the base member F is not particularly limited, for example, is several µm to several-tens µm. The width or the length of the base member F is also not particularly limited but is adequately determined depending on the intended use.

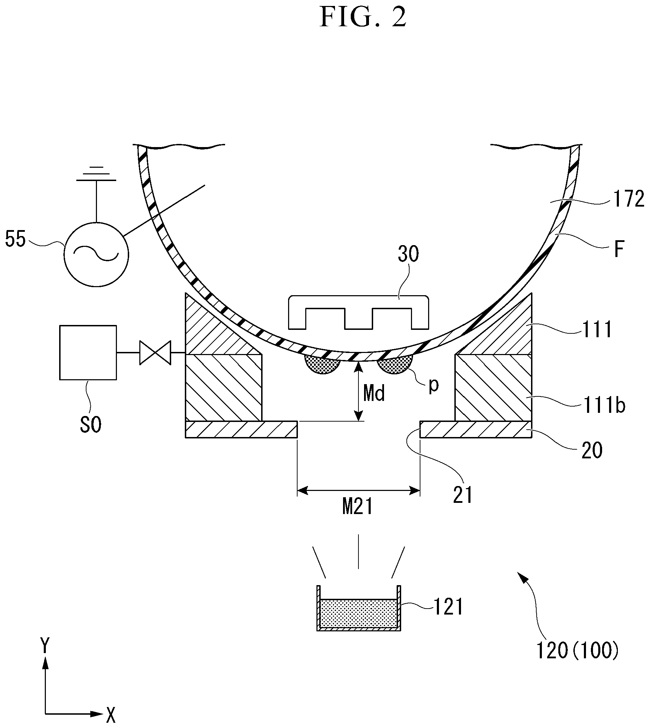

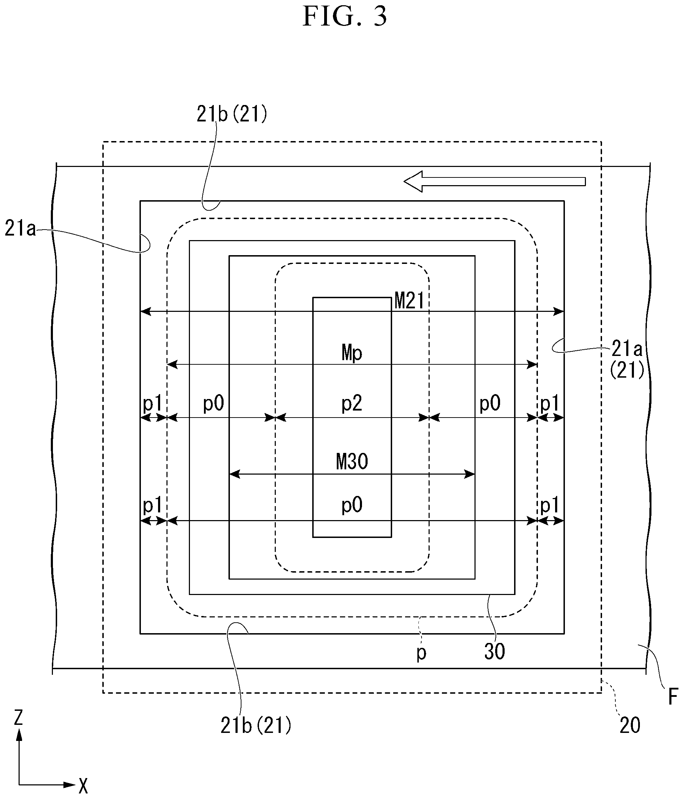

FIG. 2 is an enlarged cross-sectional side view showing the portion near the film formation region of the thin film manufacturing apparatus according to the embodiment, and FIG. 3 is a bottom view showing the portion near the film formation region of the thin film manufacturing apparatus according to the embodiment when seen from a bottom thereof.

As shown in FIGS. 2 and 3, a shield (shielding member) 20 that serves as a film formation region and has an opening 21 is provided between the evaporation source (film-formation source) 121 and the main roller 172 in the film formation unit 120.

Furthermore, a magnet 30 is disposed at the position inside the main roller 172, that is, at the position of the back surface side (the other surface side) of the base member F.

As shown in FIGS. 2 and 3, the shield 20 has a rectangular opening 21 that determines a film formation region with respect to the base member F that is wound around the main roller 172. The shield 20 is only necessary to cover the base member F other than the opening 21, and the outline of the shield 20 is schematically shown in FIG. 3.

The shield 20 is a plate-shaped conductor and the electrical potential thereof is a ground potential (grounding state, the shield 20 is grounded). The shield 20 is disposed so as to be substantially parallel to the base member F that is wound around the main roller 172. Note that, the shield 20 may be floating (may have a floating potential) in accordance with conditions for film formation. Also in the case where a predetermined electrical potential is applied to the shield 20 by use of a known power supply, it means that the shield 20 is floating.

The shield 20 is connected to the partition plate (mask) 111 via a shield plate 111b at the outer position of the opening 21 of the main roller 172. The shield plate 111b surrounds the outside of the opening portion 111a provided at the partition plate 111. The shield plate 111b tightly seals a space between the shield 20 and the partition plate 111. The shield 20 and the shield plate 111b are disposed so as to surround a plasma generation region p at the outside thereof.

The shape of the plasma generation region p corresponds to that of the magnet 30.

The magnet 30 is disposed so as to form a magnetic flux directed to the outside of the main roller 172.

In the embodiment, the magnet 30 is formed in an annular shape, particularly, in a substantially rectangular annular shape so as to have both poles that can generate plasma. Accordingly, as shown in FIG. 3, the plasma generation region p is set in an annular shape with respect to the surface (one surface) of the base member F. The direction of movement of the base member F in the region near the opening 21 is the X-direction.

The diameter Mp of the plasma generation region p in the X-direction is defined by the diameter M30 that is the width of the outline of the magnet 30 in the X-direction. The diameter Mp of the plasma generation region p in the X-direction means the length in the X-direction in the rectangular region in which plasma is present. The diameter M30 of the magnet 30 in the X-direction means the length of the side extending in the X-direction of the magnet 30 having a substantially-rectangular shaped outline.

As shown in FIG. 3, the diameter M21 of the opening 21 of the shield 20 in the X-direction means the length in which the opening edges 21a and 21a are separated from each other in the X-direction. The opening edges 21a and 21a face to each other in parallel. The opening edges 21a and 21a extend in the Z-direction, that is, in the direction orthogonal to the direction of movement of the base member F. The opening edges 21b and 21b orthogonal to the opening edges 21a and 21a extend in the X-direction, that is, the direction of movement of the base member F.

The opening edges 21b and 21b face to each other in parallel.

The diameter M21 of the opening 21 of the shield 20 with respect to the diameter M30 in the X-direction of the magnet 30 having a substantially-rectangular shaped outline is determined as follows with reference to FIG. 3.
(A1) The diameter M21 is in a range of less than or equal to the outer diameter M30 + 20 mm (a range of less than or equal to the value obtained by adding 20 mm to the outer diameter M30).
(A2) The diameter M21 is in a range of the outer diameter M30 + 0 mm to 20 mm (a range of the value of the outer diameter M30 to the value obtained by adding 20 mm to the outer diameter M30).
(A3) The diameter M21 is in a range of the outer diameter M30 - 20 mm to 20 mm (a range of the value obtained by subtracting 20 mm from the outer diameter M30 to the value obtained by adding 20 mm to the outer diameter M30).

Furthermore, a ratio of the diameter M21 of the opening 21 of the shield 20 to the outer diameter M30 of the magnet 30 having a substantially-rectangular shape is set in a range of less than or equal to 110/90 and in a range of 86/90 to 106/90.

Accordingly, the diameter M21 of the opening 21 of the shield 20 with respect to the diameter Mp of the plasma generation region in the X-direction is set in a range of less than or equal to 110/100 and in a range of 86/100 to 106/100.

As shown in FIG. 3, the length of the shield 20 in the Z-direction in which the opening edges 21b and 21b are separated from each other is set to be smaller than the width of the base member F in the Z-direction.

The opening size M21Z of the opening 21 of the shield 20 with respect to the diameter M30Z in the Z-direction of the magnet 30 is determined as follows with reference to FIG. 3.
(B1) The opening size M21Z is in a range of less than or equal to the diameter M30Z of the magnet 30 + 20 mm (a range of less than or equal to the value obtained by adding 20 mm to the diameter M30Z).
(B2) The opening size M21Z is in a range of the diameter M30Z of the magnet 30 + 0 mm to 20 mm (a range of the value of the outer diameter M30 to the value obtained by adding 20 mm to the diameter M30Z).
(B3) The opening size M21Z is in a range of the diameter M30Z of the magnet 30 - 20 mm to 20 mm (a range of the value obtained by subtracting 20 mm from the diameter M30Z to the value obtained by adding 20 mm to the outer diameter M30).

Furthermore, a ratio of the opening size M21Z of the opening 21 of the shield 20 to the diameter M30Z of the magnet 30 is set in a range of less than or equal to 180/160 and in a range of 140/160 to 180/160.

Regarding the position of the shield 20 with respect to the surface (one surface) of the base member F that is wound around the main roller 172, as shown in FIG. 2, the shield 20 is separated from the surface (one surface) of the base member F in the Y-direction such that the separation distance in the Y-direction becomes Md.

With respect to the diameter M30 of the magnet 30 in the X-direction, the shield 20 is set such that the separation distance Md in the Y-direction with respect to the surface (one surface) of the base member F that is wound around the main roller 172 is in a range of 3 to 35 mm or in a range of 7 to 35 mm (refer to FIG. 2).

Moreover, a plasma-generating power supply 55 is connected to the main roller 172 and electric power for generating plasma can be supplied thereto. The plasma-generating power supply 55 is an alternating-current source or a direct-current source. The plasma-generating power supply 55 constitutes a plasma generator.

The thin film manufacturing apparatus 100 has the above-described configuration.

Note that, not shown in the drawings but the thin film manufacturing apparatus 100 includes a controller that controls the evaporation source 121, the transfer mechanism 170, the vacuum pump PI, the gas supplier S0, the plasma-generating power supply 55, the magnet 30, or the like. The aforementioned controller is configured of a computer including a CPU or a memory and controls the entire operation of the thin film manufacturing apparatus 100.

Furthermore, the configuration of the thin film manufacturing apparatus 100 is not limited to the configuration shown in the drawings. For example, the arrangement and the size of the film formation unit 120, the evaporation source 121, the transfer unit 130, and the collection unit 160 as well as the evaporator and the types of supply gases, and the electrical potential to be supplied thereto, or the like can be suitably modified. At least one of the above-described constituent elements of the thin film manufacturing apparatus 100 may not be provided.

Regarding the film formation in the thin film manufacturing apparatus 100, firstly, the inside of the vacuum chamber 110 is vacuumed, and the film formation unit 120, the transfer unit 130, and the collection unit 160 are maintained in a predetermined degree of vacuum.

Additionally, the transfer mechanism 170 supporting the base member F is driven, and the base member F is fed from the unwinding roller 171 to the rewinding roller 173. In the film formation unit 120, the base member F is fed (moved) in the X-direction.

Note that, as described below, positive electrodes, power collectors, or the like are formed on a predetermined region on the base member F in advance.

With regard to the film formation unit 120, a gas containing nitrogen is introduced from the gas supplier SO into the inside of the film formation unit 120.

Moreover, in the film formation unit 120, electric power for generating plasma is supplied to the main roller 172 from the plasma-generating power supply 55 connected thereto. At the same time, in the film formation unit 120, due to the electric power supplied from the power supply connected thereto, the magnet 30 generates a magnetic flux.

Consequently, plasma is generated in the plasma generation region p.

In the film formation unit 120, the evaporation source 121 is heated by, for example, an electron beam or the like, evaporates a vapor-deposition material containing lithium (material for forming a film), and generates a vaporization flow of the vapor-deposition material containing lithium (material for forming a film) that is emitted toward the base member F on the main roller 172.

In this situation, the region of the base member F on which the vaporization flow of the vapor-deposition material containing lithium (material for forming a film) reaches is regulated by the opening 21 of the shield 20.

At the area near the opening 21 of the shield 20, the deposition particles containing lithium that are activated by nitrogen gas converted into plasma are deposited on the surface of the base member F as an electrolyte layer containing nitrogen.

Simultaneously, as the film formation region is determined with respect to the moving base member F by the opening 21, the film characteristics thereof can be uniform in the film-thickness direction.

Specifically, in the case of forming a film on the base member F while the base member moves in the X-direction, film formation particles are sequentially attached to the surface of the moving base member F. Therefore, if there is a difference in plasma activation due to a position in accordance with the movement of the base member, the film characteristics vary in the film-thickness direction. In contrast, in the embodiment, since plasma that is not activated can be shielded by the shield 20 other than the portion at which the opening 21 is formed, the film characteristics do not vary in the film-thickness direction.

In the thin film manufacturing apparatus 100 according to the embodiment, as a result of using the shield 20, in the direction of movement of the base member F which is the X-direction, the distance in which film deposition is carried out by a low-activated plasma generated at a peripheral edge portion and a center portion of plasma and the distance in which film deposition is carried out by a high-activated plasma corresponding to the shape of the magnet 30 can be set to be substantially uniform in the Z-direction.

For this reason, in the direction orthogonal to the direction of movement of the base member F which is the Z-direction, the film composition can be set so that the film characteristics becomes uniform. Particularly, the film composition can be set such that the proportion of N contained in the film becomes uniform.

Consequently, in the thin film manufacturing apparatus 100 according to the embodiment, since a base bias and a film formation region are optimized by the shield 20, it is possible to sufficiently nitride an electrolyte layer by shielding the plasma other than the sufficiently activated plasma, and it is possible to manufacture the electrolyte layer having improved film characteristics, particularly, improved ion conductivity.

In addition, the case where the thin film manufacturing apparatus 100 according to the embodiment is a roll-to-roll apparatus is explained; however, the invention is not limited to the configuration thereof, and a configuration may be adopted which forms a film on a single-wafer substrate in the middle of transferring the substrate.

Furthermore, the thin film manufacturing apparatus according to the embodiment may be provided with not only the film formation unit of the electrolyte layer but also another film formation unit or another processing unit.

Hereinafter, a thin film manufacturing apparatus according to a second embodiment of the invention will be described with reference to drawings.

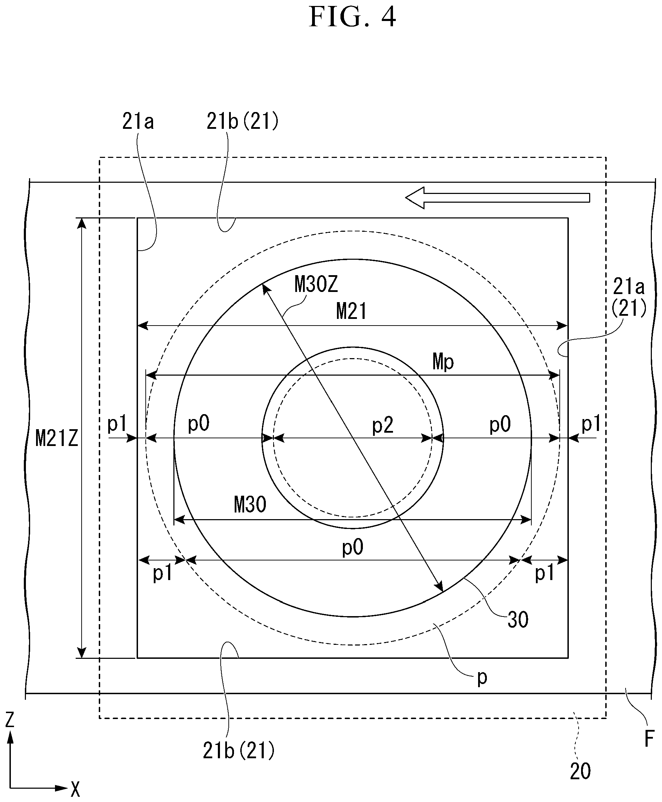

FIG. 4 is a bottom view showing the portion near the film formation region of the thin film manufacturing apparatus according to the embodiment when seen from a bottom thereof. The embodiment is different from the aforementioned first embodiment in point related to a magnet, and otherwise, identical reference numerals are used for the elements which correspond to those of the above-described first embodiment, and the explanations thereof are omitted or simplified here.

The magnet 30 according to the embodiment is formed in an annular shape, particularly, in a ring shape so as to have both poles that can generate plasma. Accordingly, as shown in FIG. 4, the plasma generation region p is set in a ring shape with respect to the surface (one surface) of the base member F. The direction of movement of the base member F in the region near the opening 21 is the X-direction.

The diameter Mp of the plasma generation region p in the X-direction is defined by the maximum diameter M30 that is the width of the outline of the magnet 30 in the X-direction. The diameter Mp of the plasma generation region p in the X-direction means the maximum length in which plasma in the X-direction is present. The diameter M30 of the magnet 30 in the X-direction means the maximum length of the magnet 30 in the X-direction.

The diameter M21 of the opening 21 of the shield 20 with respect to the diameter M30 in the X-direction of the magnet 30 is determined as follows with reference to FIG. 4.
(C1) The diameter M21 is in a range of less than or equal to the outer diameter M30 + 20 mm (a range of less than or equal to the value obtained by adding 20 mm to the outer diameter M30).
(C2) The diameter M21 is in a range of the outer diameter M30 + 0 mm to 20 mm (a range of the value of the outer diameter M30 to the value obtained by adding 20 mm to the outer diameter M30).
(C3) The diameter M21 is in a range of the outer diameter M30 - 20 mm to 20 mm (a range of the value obtained by subtracting 20 mm from the outer diameter M30 to the value obtained by adding 20 mm to the outer diameter M30).

Furthermore, a ratio of the diameter M21 of the opening 21 of the shield 20 to the outer diameter M30 of the magnet 30 is set in a range of less than or equal to 110/90 and in a range of 86/90 to 106/90.

Accordingly, the diameter M21 of the opening 21 of the shield 20 with respect to the diameter Mp of the plasma generation region in the X-direction is set in a range of less than or equal to 110/100 and in a range of 86/100 to 106/100.

The opening size M21Z of the opening 21 of the shield 20 with respect to the diameter M30Z in the Z-direction of the magnet 30 is determined as follows with reference to FIG. 4.
(B1) The opening size M21Z is in a range of less than or equal to the diameter M30Z of the substantially-rectangular shaped magnet 30 + 20 mm (a range of less than or equal to the value obtained by adding 20 mm to the diameter M30Z).
(B2) The opening size M21Z is in a range of the diameter M30Z of the substantially-rectangular shaped magnet 30 + 0 mm to 20 mm (a range of the value of the outer diameter M30 to the value obtained by adding 20 mm to the diameter M30Z).
(B3) The opening size M21Z is in a range of the diameter M30Z of the substantially-rectangular shaped magnet 30 - 20 mm to 20 mm (a range of the value obtained by subtracting 20 mm from the diameter M30Z to the value obtained by adding 20 mm to the outer diameter M30).

Furthermore, a ratio of the opening size M21Z of the opening 21 of the shield 20 to the diameter M30Z of the magnet 30 is set in a range of less than or equal to 180/160 and in a range of 140/160 to 180/160.

In the embodiment, in the direction of movement of the base member F which is the X-direction, the distance in which film deposition is carried out by a low-activated plasma generated at a peripheral edge portion and a center portion of plasma and the distance in which film deposition is carried out by a high-activated plasma corresponding to the shape of the magnet 30 having a substantially-rectangular shaped outline can be set to be substantially uniform in the Z-direction.

For this reason, in the direction orthogonal to the direction of movement of the base member F which is the Z-direction, the film composition can be set so that the film characteristics become uniform. Particularly, the film composition can be set such that the proportion of N contained in the film becomes uniform.

Here, research of the film characteristics of the thin film that has been formed in the direction of movement of the base member F is carried out.

As shown in FIG. 4, at the position near the center of the opening 21 in the Z-direction, the base member F that moves in the direction from the opening edge21a at the right side shown in the drawing to the left side is firstly and slightly exposed to the outside region p1 having a low level of activation, and thereafter moves to the sufficiently-activated plasma region p0.

At this time, an electrolyte layer having the high film characteristics is formed. Next, the base member F passes through the inside region p2 having a low level of activation, and thereafter is again moves to the sufficiently-activated plasma region p0 located at the left side shown in the drawing. At this time, an electrolyte layer having the high film characteristics is formed. Finally, the base member F is slightly exposed to the outside region p1 that has a low level of activation and is located at the left side, and thereafter moves to the shielded region from the opening edge21a at the left side shown in the drawing.

In contrast, as shown in the lower side of FIG. 4, at the position near the position near the opening edge21b of the opening 21 in the Z-direction, the base member F that moves in the direction from the opening edge21a at the right side shown in the drawing to the left side is firstly moves to the outside region p1 having a low level of activation. Thereafter, the base member F moves to the sufficiently-activated plasma region p0. The base member F does not pass through the inside region p2 at the position in the Z-direction shown as an example. Subsequently, the base member F passes through the outside region p1 that has a low level of activation and is located at the left side, and thereafter moves to the shielded region from the opening edge21a at the left side shown in the drawing.

As stated above, in the shield 20 according to the embodiment, the diameter M21 of the opening 21 satisfies predetermined relationships with respect to the diameter Mp of the plasma generation region in the X-direction. Consequently, regarding the base member F moving in the X-direction, a ratio of the distance in which the base member moves in the sufficiently-activated plasma region p0 to the distance in which the base member moves in the outside region p1 and the inside region p2 which have a low level of activation is substantially made uniform at each of the positions in the Z-direction.

Accordingly, the electrolyte layer having the uniform film characteristics can be formed on the entire region in the Z-direction on the base member F moving in the X-direction.

Furthermore, in the embodiment, in the thin film manufacturing apparatus 100 serving as a roll-to-roll apparatus, the electrolyte layer having the uniform film characteristics can be continuously formed on the entire region in the Z-direction.

Additionally, since the outside region p1 having a low level of activation is limited by the shield 20, the film characteristics of the electrolyte layer can be improved.

### Examples

Hereinafter, Examples according to the invention will be described.

Here, as specific examples of the thin film manufacturing apparatus of the invention, film formation test will be described.

### <Experimental Examples 1 to 11>

A LiPON film was formed by the aforementioned thin film manufacturing apparatus 100, and ion conductivity that is the film quality was measured.

Conditions for film formation were as follows.
Internal pressure of film formation unit: 0.1 to 0.3 Pa
Plasma supply power: 30 W
Gas introduction portion: Position near the shield
Gas flow rate: 100 sccm
Feeding speed of base member F: 0.5 to 5 m/min
Material of base member F: copper foil and PET resin base member

Furthermore, Experimental Examples 1 to 4, the sizes of the shield 20 were set as follows.
Diameter M21 of opening 21 in X-direction: 70 to 166 mm
Separation distance Md of shield 20 in Z-direction: 3 to 35 mm
Diameter M30 of magnet 30 in X-direction: 90 mm

Moreover, electrical potentials of the shield 20 were grounding potential (ground: GND) and floating potential (floating: FTG).

The results are shown in Table 1.

**(Table 1)**

| | M21 (mm) | Md (mm) | ELECTRICAL POTENTIAL OF SHIELD | ION CONDUCTIVITY (Scm-1) |
|---|---|---|---|---|
| EXPERIMENTAL EXAMPLE 1 | 166 | 7 | GND | 3. 00E-07 |
| EXPERIMENTAL EXAMPLE 2 | 86 | 35 | GND | 3. 00E-07 |
| EXPERIMENTAL EXAMPLE 3 | 86 | 7 | GND | NG |
| EXPERIMENTAL EXAMPLE 4 | 90 | 7 | GND | 8. 00E-07 |
| EXPERIMENTAL EXAMPLE 5 | 106 | 7 | GND | 8. 00E-07 |
| EXPERIMENTAL | 110 | 7 | GND | 6. 00E-07 |
| EXPERIMENTAL EXAMPLE 7 | 114 | 7 | GND | 3. 00E-07 |
| EXPERIMENTAL EXAMPLE 8 | 106 | 35 | GND | 5. 00E-07 |
| EXPERIMENTAL EXAMPLE 9 | 106 | 3 | GND | 8. 00E-07 |
| EXPERIMENTAL EXAMPLE 10 | 86 | 7 | FTG | 8. 00E-07 |
| EXPERIMENTAL EXAMPLE 11 | 70 | 7 | FTG | 7. 00E-07 |

Note that, in Experimental Example 3, film formation such that ion conductivity can be measured was impossible.

From the aforementioned results, as shown in Experimental Examples 4, 5, 6, 9, 10, and 11, it was determined that, by setting the diameter M21 of the opening 21 to be smaller than the outer diameter of the magnetic circuit +20 mm (smaller than the value obtained by adding 20 mm to the outer diameter of the magnetic circuit), the electrolyte layer having a high ion conductivity can be formed. That is, it was understood that since the diameter of the plasma generation region p generated at this time is 100 mm, in the case of providing the shield 20 such that the diameter M21 of the opening 21 with respect to the diameter of the plasma generation region p is less than or equal to 110/100, regardless of the size of the magnetic circuit, it is possible to form the electrolyte layer having a high ion conductivity.

Similarly, it was understood that, in the case of providing the shield 20 such that the diameter M21 of the opening 21 with respect to the diameter M30 of the magnet (magnetic circuit) 30 is less than or equal to 110/90, regardless of the size of the magnetic circuit, it is possible to form the electrolyte layer having a high ion conductivity.

Moreover, it was seen that, in the case where the shield 20 is set to the ground potential (GND), it is only necessary to set the diameter M21 of the opening 21 to be the value obtained by adding the outer diameter of the magnetic circuit to a range of +0 to 20 mm (that is, to be in a range of the value of the outer diameter of the magnetic circuit to the value obtained by adding 20 mm to the outer diameter of the magnetic circuit). Similarly, it is understood that, in the case where the shield 20 is set to a floating potential (FTG), it is only necessary to set the diameter M21 of the opening 21 to be the value obtained by adding the outer diameter of the magnet (magnetic circuit) 30 to a range of -20 to +20 mm (that is, to be in a range of the value obtained by subtracting 20 mm from the outer diameter of the magnetic circuit to the value obtained by adding 20 mm to the outer diameter of the magnetic circuit).

### Industrial Applicability

As an available example of the invention, an apparatus can be adopted which carries out: film formation of an electrolyte layer such as LiPON or the like which contains lithium and nitrogen by use of plasma containing a vapor-deposition material containing lithium and nitrogen; or film formation of a positive-electrode material such as LCO or the like which contains lithium and oxygen by use of plasma containing a vapor-deposition material containing lithium and oxygen.

### DESCRIPTION OF REFERENCE NUMERALS

100 thin film manufacturing apparatus
20 shield (shielding member)
21 opening
21a opening edge
21b opening edge
30 magnet
55 plasma-generating power supply
111b shield plate
120 film formation unit 121
evaporation source (film-formation source supplier)
170 transfer mechanism (substrate transfer unit)
172 main roller
F, F0 base member (substrate)
F2 electrolyte layer (thin film)
M21 diameter
M30 diameter
Md separation distance
Mp diameter
p plasma generation region
S0 gas supplier

## Claims

1. An apparatus that causes film formation particles to adhere to a surface of a substrate moving in a hermetically-sealable chamber and thereby forms a thin film thereon, comprising:
a plasma generator that generates plasma in the chamber;
a substrate transfer unit that transfers the substrate in the chamber;
a film-formation source supplier that supplies film formation particles to the surface of the substrate; and
a film-formation region limiter that limits a film-formation region to which the film formation particles are to be formed on the surface of the substrate from the film-formation source supplier, wherein
the plasma generator comprises: a magnet located at the other surface of the substrate; and a gas supplier that supplies a film forming gas to near the surface of the substrate,
the film-formation region limiter includes a shield that is located close to the surface of the substrate and has an opening, and
a ratio of a diameter of the opening of the shield to a diameter of the plasma generated by the plasma generator in a direction along the surface of the substrate is in a range of less than or equal to 110/100.

2. The thin-film manufacturing apparatus according to claim 1, wherein
a ratio of a diameter of the opening of the shield to a diameter of the magnet in a direction along the surface of the substrate is in a range of less than or equal to 110/90.

3. An apparatus that causes film formation particles to adhere to a surface of a substrate moving in a hermetically-sealable chamber and thereby forms a thin film thereon, comprising:
a plasma generator that generates plasma in the chamber;
a substrate transfer unit that transfers the substrate in the chamber;
a film-formation source supplier that supplies film formation particles to the surface of the substrate; and
a film-formation region limiter that limits a film-formation region to which the film formation particles are to be formed on the surface of the substrate from the film-formation source supplier, wherein
the plasma generator comprises: a magnet located at the other surface of the substrate; and a gas supplier that supplies a film forming gas to near the surface of the substrate,
the film-formation region limiter includes a shield that is located close to the surface of the substrate and has an opening, and
a length obtained by subtracting a diameter of the opening of the shield from a diameter of the plasma generated by the plasma generator in a direction along the surface of the substrate is in a length range of less than or equal to a length obtained by adding 20 mm to an outer diameter of the magnet.

4. The thin-film manufacturing apparatus according to claim 3, wherein
the film-formation region limiter is grounded and thereby has a ground potential, and
a diameter of the opening is set in a length obtained by adding a length range of 0 mm to 20 mm to an outer diameter of the magnet.

5. The thin-film manufacturing apparatus according to claim 3, wherein
the film-formation region limiter has a floating potential, and
a diameter of the opening is set in a length obtained by adding a length range of -20 mm to +20 mm to an outer diameter of the magnet.

6. The thin-film manufacturing apparatus according to any one of claims 1 to 5, wherein
a diameter of the opening is determined in a predetermined range in a direction of movement of the substrate.

7. The thin-film manufacturing apparatus according to any one of claims 1 to 6, wherein
the film forming gas supplied by the gas supplier contains nitrogen, and
the film-formation source supplier supplies a film-formation source that contains lithium.
